(19)

Europäisches
Patentamt

European
Patent Office

Office européen
des brevets

(11) **EP 3 683 983 A1**

(12) **EUROPEAN PATENT APPLICATION**

(43) Date of publication:
**22.07.2020 Bulletin 2020/30**

(51) Int Cl.:
**H04B 10/69** (2013.01)

(21) Application number: **19152525.2**

(22) Date of filing: **18.01.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Melexis Technologies NV**
**3980 Tessenderlo (BE)**

(72) Inventor: **LIVEZEY, Darrell**
**Brookline, NH-03033 (US)**

(74) Representative: **DenK iP**
**Leuvensesteenweg 203**
**3190 Boortmeerbeek (BE)**

(54) **OPTICAL DETECTOR WITH DC COMPENSATION**

(57) An optical detector (100), for converting an optical signal into an electrical signal. The optical detector (100) comprising a photo sensitive device (110) adapted for receiving the optical signal and converting it into an electrical signal. The optical detector moreover comprises a bias compensation circuit (120) and a control circuit (140). The control circuit (140) is adapted to control the bias compensation circuit to maintain a bias level across the photo sensitive device (110) above a minimum bias level, and to turn the bias compensation circuit (120) off when a current through the photo sensitive device (110) is so small that the bias level across the photo sensitive device (110) is above the minimum bias level.

**FIG. 3**

## Description

### Field of the invention

The present invention relates to the field of optical detectors. More specifically it relates to the field of optical detectors which are adapted for increasing the range of background light level that can be tolerated.

### Background of the invention

Photo-diodes need to be biased to a voltage greater than some minimum bias level to work as specified. A passive bias system (i.e. a simple resistor to ground) adds the least noise to the signal but cannot maintain the required bias level if the background light generates a large amount of DC bias current. If a smaller resistor is used it can tolerate more background light, but the lower frequency corner of the signal passband will be increased and the total signal bandwidth will be reduced. This significantly degrades the systems response to signal pulses and reduces the system's ability to accurately detect small signals.

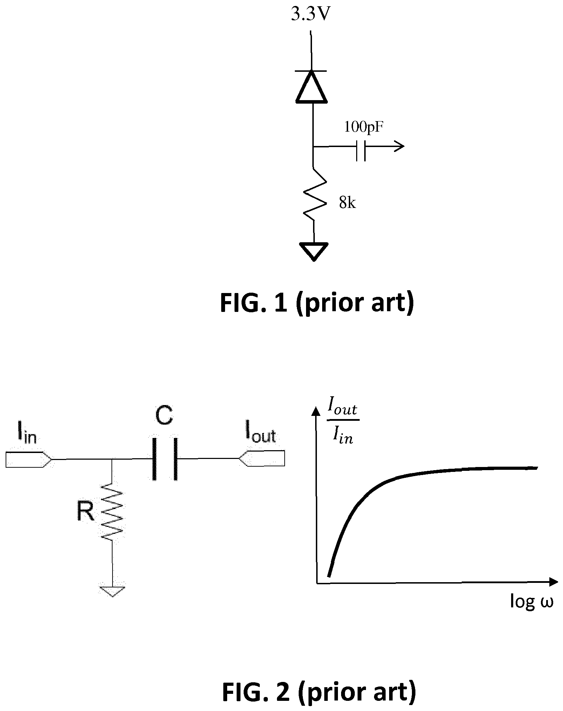

The traditional bias scheme, illustrated in FIG. 1, uses a series resistor to bias the photo diode. This scheme is simple and low noise but does a poor job of maintaining the bias voltage when the DC current is large.

The resistor and capacitor values are bound by physical size constraints and by the required minimum corner frequency. For a high pass RC filter the transfer function can be formulated as follows:

$$|I_{out}| = |I_{in}| \left[ \frac{\omega RC}{\sqrt{1 + (\omega RC)^2}} \right]$$

This transfer function is illustrated in FIG. 2. The half-power point at the "knee" of the curve is called the breakpoint.

In the approach illustrated in FIG. 1 the high pass corner frequency is dominated by the bias resistor and DC blocking capacitor. The physical size of the capacitor limits the maximum capacitance that can be used for this filter. For a specific die size a capacitor of for example 100pF. There may for example be an array of a plurality (e.g. 16) of diodes. The 16 100pF capacitors may for example occupy ~10% of the total die area. Thus, this analysis assumes the capacitor cannot be any larger than 100pF due to area constraints. To achieve a nominal 200 kHz corner frequency with a 100 pF capacitor the bias resistor must be at least 8 KOhms. If the background light generates more than $125\mu A$ then the bias voltage will be reduced by 1V which may degrade performance.

In view of the limited design choices for the resistance and capacitance for a prior art photo-diode biasing circuit, there is a need for optical detectors which can cope with varying background light levels.

### Summary of the invention

It is an object of embodiments of the present invention to provide a good optical detector under varying background light levels.

The above objective is accomplished by a method and device according to the present invention.

In a first aspect embodiments of the present invention relate to an optical detector, for converting an optical signal into an electrical signal. The optical detector comprises a photo sensitive device adapted for receiving the optical signal and converting it into an electrical signal. The optical detector moreover comprises a bias compensation circuit and a control circuit. The control circuit is adapted to control the bias compensation circuit to maintain a bias level across the photo sensitive device above a minimum bias level, and the control circuit is adapted to turn the bias compensation circuit off when a current through the photo sensitive device is so small that the bias level across the photo sensitive device is above the minimum bias level.

It is an advantage of an optical detector according to embodiments of the present invention that it can operate under a varying range of background light levels. This is achieved by monitoring the background light level and by turning on the active bias only when the bias level crosses a threshold. Thus, no extra noise is generated during normal operation and the bias level is maintained by turning on the bias compensation circuit when the bias level would otherwise decrease beyond a minimum bias level.

In embodiments of the present invention the optical detector comprises a bias resistor and the bias compensation circuit comprises a variable current source, and the photo sensitive device is electrically connected in series with a parallel connection of the variable current source and the bias resistor. The optical detector moreover comprises a capacitor which has a first and a second terminal of which the first terminal is electrically connected with a node between the bias resistor and the photo sensitive device. The control circuit thereby is adapted for controlling the current through the current source such that, during operation, the bias level of the photo sensitive device can be kept above the minimum bias level and such that, during operation, no current is flowing through the current source when a current through the photo sensitive device is so small that the bias level across the photo sensitive device is above the minimum bias level.

During operation optical signal observed by the photo sensitive device is converted into an electrical signal which can be detected at the second terminal of the capacitor. The optical signal may for example comprise light pulses.

It is an advantage of embodiments of the present invention that the variable current source can adjust the DC current through the bias resistor such that the bias level of the photo sensitive device can be kept above a minimum bias level. It is an advantage of embodiments of the present invention that the photo sensitive device speed and responsivity can be maintained by ensuring a minimum bias level over the photo sensitive device.

It is moreover advantageous that no current is flowing through the current source when a current through the photo sensitive device is so small that the bias level of the photo sensitive device is above the minimum bias level. It is, hence, an advantage of embodiments of the present invention that no additional noise is generated when the DC current through the photo sensitive device is so small that the bias level of the photo sensitive device is above the minimum bias level.

In embodiments of the present invention the control circuit may comprise a comparator for comparing the bias level with the minimum bias level.

In embodiments of the present invention the control circuit comprises a voltage measurement circuit for comparing the bias level with the minimum bias level.

The voltage measurement circuit may be an error amplifier adapted for amplifying the difference between the bias level and the minimum bias level and for using the amplified signal for controlling the bias compensation circuit.

The error amplifier may for example be integrated in an embodiment comprising a current source and a bias resistor as described above. This may for example be in a configuration wherein an output node of the error amplifier is electrically connected with an input of the variable current source, and a first input node of the error amplifier is electrically connected with a node between the bias resistor and the photo sensitive device, and, during operation, a reference voltage is applied to a second input node of the error amplifier.

The minimum bias level can be determined by the reference voltage at the second input node of the error amplifier. As soon as the DC current through the photo sensitive device results in a voltage at the first input node of the error amplifier which rises above the reference voltage at the second input node, the error amplifier will generate a signal at its output node such that a current is generated by the variable current source which results in a decreased DC current in the bias resistor and which hence results in an increased bias level over the photo sensitive device.

When the voltage at the first input node of the error amplifier is below the reference voltage at the second input node, there will be no signal at the output of the error amplifier which results in a DC current generated by the variable current source.

It is hence an advantage of embodiments of the present invention that no additional noise is generated when the DC current through the photo sensitive device is so small that the voltage at the first input node of the error amplifier is below the reference voltage.

It is, hence, an advantage of embodiments of the present invention that very large DC currents can be managed without affecting the corner frequency and without adding any additional noise when the DC current is small.

In embodiments of the present invention the voltage measurement circuit is an analog-to-digital converter for converting the bias level to a digital presentation and wherein the control circuit is adapted for using this digital value to control the current source.

In embodiments of the present invention the control circuit comprises a voltage source adapted for generating a reference voltage and wherein the control circuit is adapted for determining the minimum bias level from the reference voltage. The voltage source may for example be electrically connected to the second input node of the error amplifier. The voltage source is adapted for applying a reference voltage to the second input node.

In embodiments of the present invention the voltage source is adapted for adjusting the reference voltage.

It is an advantage of embodiments of the present invention that, depending on the application requirements, a different reference voltage can be set. The bias current that triggers a switch from the basic mode to the current cancelation mode can be adjusted by varying the threshold voltage and the bias resistor.

In embodiments of the present invention the capacitor and the bias resistor are selected such that a low pass filter is obtained with a corner frequency below a predefined frequency. This predefined frequency may for example be 200 kHz. Depending on the application another corner frequency may be preferable.

It is an advantage of embodiments of the present invention that the undershoot after a large input signal is limited by choosing a low pass filter with a corner frequency below the predefined frequency. The maximum undershoot and the optimum corner frequency are application dependent. They depend for example on the pulse width and shape.

In embodiments of the present invention the bias level is an adjustable bias level.

In embodiments of the present invention the bias resistor is an adjustable bias resistor.

In a second aspect embodiments of the present invention relate to a light detection and ranging system comprising at least one optical detector according to embodiments of the present invention. The light detection and ranging system moreover comprises a processing unit adapted for processing signals from the second terminal of the capacitor of the at least one optical detector.

In embodiments of the present invention the light detection and ranging system comprises a signal generation device adapted to emit at least one output signal and the optical detector is adapted to receive the at least one output signal. Before it is received by the optical detector the at least one output signal may be reflected against an object. Analysis of the received signal (e.g. determining the delay of the received signal) may for example be used to determine the position of the object.

In embodiments of the present invention the signal generation device is a LED or a laser.

In a third aspect embodiments of the present invention relate to a method for detecting an optical signal and converting it into an electrical signal. The method comprises receiving the optical signal with a photo sensitive device while maintaining the bias level across the photo sensitive device above a minimum bias level using a bias compensation circuit, and turning of the bias compensation circuit when a current through the photo sensitive device is so small that the bias level across the photo sensitive device is above the minimum bias level.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

## Brief description of the drawings

FIG. 1 shows a schematic drawing of a prior art biasing scheme using a series resistor to bias the photo-diode.

FIG. 2 shows the transfer circuit of the biasing circuit illustrated in FIG. 1.

FIG. 3 shows a schematic drawing of an optical detector in accordance with embodiments of the present invention.

Any reference signs in the claims shall not be construed as limiting the scope. In the different drawings, the same reference signs refer to the same or analogous elements.

## Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In a first aspect embodiments of the present invention relate to an optical detector 100, for converting an optical signal into an electrical signal (e.g. light pulses into electrical pulses). The optical detector 100 comprises a photo sensitive device 110, a bias compensation circuit 120 and a control circuit 140. Such a photo sensitive device may for example be a photo-diode such as a conventional photodiode, a PIN photodiode, an avalanche photodiode and so on.

An optical detector in accordance with embodiments of the present invention is adapted for monitoring the background light and turning on the active bias compensation circuit 120 whenever the background light crosses a selected threshold. This functionality can be implemented with a variety of circuits. The key functionality includes a control circuit 140 that controls a variable bias compensation circuit to maintain a certain minimum bias level across the photo sensitive device. An important element of this scheme is that the control circuit turns the variable bias circuit completely off if it is not needed.

It is thereby advantageous that the current through the photo sensitive device can be managed without violating the bias limits of the photo sensitive device. Moreover, the noise at lower DC current levels will be better than systems that use continuous active bias schemes. At higher DC current levels the bias compensation circuit is turned on to maintain a bias level across the photo sensitive device. At lower DC current levels the bias compensation circuit is turned off. The threshold between higher and lower current levels is thereby determined by the minimum bias level of the photo sensitive device.

In other words, the control circuit 140 is adapted to control the bias compensation circuit to maintain a bias level across the photo sensitive device 110 above a minimum bias level, and the control circuit turns the bias compensation circuit 120 off when a current through the photo sensitive device 110 is so small that the bias level across the photo sensitive device 110 is above the minimum bias level.

In embodiments of the present invention the optical detector comprises a bias resistor 121 for biasing the photo sensitive device and the bias compensation circuit 120 comprises a variable current source 122. The photo sensitive device 110 is electrically connected in series with a parallel connection of the variable current source 122 and the bias resistor 121. The optical detector 100 moreover comprises a capacitor 160 having a first and a second terminal of which the first terminal is electrically connected with a node between the bias resistor 121 and the photo sensitive device 110. The control circuit 140 is adapted for controlling the current through the current source 120 such that, during operation, the bias level of the photo sensitive device 110 can be kept above the minimum bias level and such that, during operation, no current is flowing through the current source when a current through the photo sensitive device 110 is so small that the bias level across the photo sensitive device (110) is above the minimum bias level.

As the current source can be switched off if it is not required for reaching the minimum bias level. Thus, the amount of shot noise which would be generated by the current source can be significantly reduced. This switching off of the current source is possible because during normal conditions a true resistor can be used to bias the diode. By using a true resistor no extra noise is generated which would be generated across the PN junctions of a transistor when using a transistor for controlling the bias level during normal bias conditions.

It is an advantage of embodiments of the present invention that it is possible to compensate for an increased amount of background light. It is moreover advantageous that the performance is not degraded in the absence of bright background light by the presence of the compensation circuitry. In embodiments of the present invention the bias compensation is only turned on when the background light signal is large enough to significantly degrade performance. Thus, the performance is not degraded under nominal conditions where the background light is not a factor. This in comparison with bias systems in which full time active compensation is implemented.

This as opposed to conventional bias schemes which are continuous, and which do not include any switching. In a pure passive bias system, such as illustrated in FIG. 1 it is not possible to tolerate a level of background light which can be tolerated in an optical detector according to embodiments of the present invention and at the same time maintain the same required bandwidth.

In the configuration illustrated in FIG. 1 the DC current should be limited to maintain enough diode bias level. Assuming a nominal bias voltage of 3.3V the photo diode bias voltage is simply:

$$Vbias = 3.3 - 8000 * Idc$$

with Vbias the bias level and Idc the DC current through the diode. If the diode bias level below 2V the diode speed and responsivity may degrade over process and temperature corners.

The bias on the diode may for example be maintained above 2V bias on the diode, by keeping the DC current less than:

$$Imax_{2V} = (3.3V-2V) / 8000 = 163 \ \mu A$$

If the diode bias voltage falls below 1V the diode performance will rapidly degrade even under nominal conditions. To maintain 1V bias on the diode the DC current must be less than:

$$Imax_{1V} = (3.3-1V)/8000 = 288 \ \mu A$$

If, for the diode in this example, the DC current can increase above 163 μA the system accuracy and sensitivity cannot be guaranteed over all process and temperature corners. If the DC current can increase above 288 μA the accuracy and sensitivity cannot be guaranteed even under nominal conditions.

In embodiments of the present invention this excess of DC current caused by an increased background illumination can be adjusted by the compensation circuit which is turned on by the control circuit.

In embodiments of the present invention the control circuit 140 may comprise a comparator for comparing the bias level with the minimum bias level.

In embodiments of the present invention the control circuit 140 comprises a voltage measuring circuit 141 for comparing the bias level with the minimum bias level. This may for example be an error amplifier 141 adapted for amplifying the difference between the bias level and the minimum bias level and for using the amplified signal for controlling the bias compensation circuit. In an exemplary embodiment of the present invention an output node of the error amplifier 141 is electrically connected with an input of the variable current source 122. This may for example be a voltage controlled current source, which is known to a skilled person. A first input node of the error amplifier 141 is electrically connected with a node between the bias resistor 121 and the photo sensitive device 110. During operation, a reference voltage is applied to a second input node of the error amplifier 141.

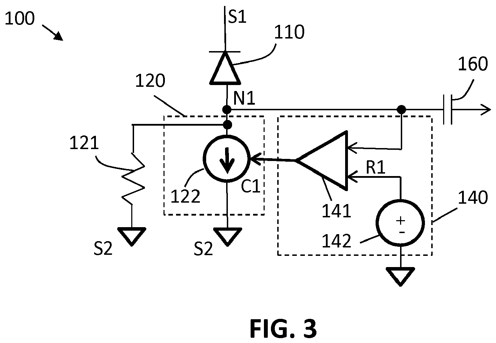

In the exemplary embodiment of the present invention illustrated in FIG. 3 the photosensitive device is connected between a first supply node S1 (e.g. 3.3V) and a bias node N1. The bias resistor 121 is connected between a second supply node S2 (e.g. ground), and the bias node N1. A controllable current source 122 is connected between the first or second supply node S1, S2 and the bias node N1 and has a control node C1. A voltage measuring device 141 has a first input connected to the bias node N1 and a second input to a reference node R1 and an output connected to the control node C1 of the controllable current source 122. The voltage measuring device 141 is configured to provide a control signal when the voltage of the bias node N1 is greater than the voltage of the reference node R1 and otherwise provide a signal switching the current source off. In FIG. 3 the photo sensitive device may be a PIN diode 110. When the background light increases the DC current from the PIN diode increases and the voltage across the resistor 121 increases. Since the resistor is in series with the PIN diode 110 the bias voltage across the PIN diode will be reduced as the background light level increases.

In embodiments of the current invention, the control circuit 140 may also be a digital control circuit. In an exemplary digital control circuit according to embodiments of the present invention the voltage measuring circuit 141 is an Analog-to-Digital converter (ADC) connected to measure and convert to a digital value the difference between the bias voltage in bias node N1 and the reference voltage in reference node R1. This digital value may then be used by the digital control circuit 140 to set the output of the controllable current source 122 to an appropriate DC current. The DC current could be set by outputting an analog voltage with a Digital-to-Analog converter (DAC) to control the current source 122 with the analog voltage in a similar way as in the embodiment with error amplifier. Or the current source could be implemented as a digitally controlled current source to output the current directly. Implementations of such digitally controlled current sources are known for a skilled person.

In a further embodiment, the voltage measuring circuit may be an ADC measuring the value of the voltage in bias node N1 across the resistor 121 or the diode 110. This digital value is then compared to a digital threshold value and the current output of the current source 122 changed accordingly. One way of adjusting the current may be adding certain amount of current if the digital value is greater than the digital threshold value and reducing the same amount of the current if the digital values is smaller than the digital threshold value. But any other methods known to a skilled person to control the current source are possible.

In all digital control circuit embodiments the measurement by the ADC may be done at the constant frequency which can be as slow as twice the desired corner frequency of the high pass filter, e.g. in the region of 400kHz for the previous examples which used a 200kHz corner frequency.

Alternatively, a simple comparator can be used for comparing the bias level with the minimum bias level. The comparator may measure the voltage across the resistor 121. When this voltage is greater than some predetermined level the comparator output goes high and enables the active bias circuit.

The active bias circuit 140 controls a variable current source 122 to cancel the excess DC bias current from the PIN diode and maintain the selected minimum bias level across the PIN diode. If the background light decreases low enough the voltage across the resistor will fall below the threshold and the active bias circuit can be turned off to reduce input noise.

In embodiments of the present invention a limiting amplifier 141 may be used to combine the comparator and control circuit functions. In this scheme a limiting amp 141 is used as an error amplifier that amplifies the difference between the preselected threshold 142 and the PIN diode bias voltage at the PIN diode bias point N1. The bias level then corresponds with the supply voltage at node S1 minus the bias voltage at N1. The threshold voltage $V_{threshold}$ is selected such that a minimum bias level can be obtained. When the bias voltage $V_{bias}$ is less than the threshold $V_{threshold}$ the output is 0, when the bias voltage is greater than the threshold the output signal is $K*(V_{bias} - V_{threshold})$ with K the amplification factor of the limiting amplifier 141. This output signal is used to control a variable current source 122 attached to the PIN diode bias point. If the amplifier gain is large enough the control circuit will continuously adjust the variable current circuit to cancel out the excess DC bias current and maintain the bias point to the selected threshold level. When the background light is reduced the PIN diode bias level will fall below the threshold, the error amplifier output will fall to 0, and the variable current source output will be effectively turned off to reduce noise.

The variable current source 122 may for example be controlled to cancel out enough DC current to keep the diode bias level greater than 2V. This approach can manage very large DC currents without affecting the corner frequency and without adding any additional noise when the DC current is small. The reason for the latter is that during operation, no current is flowing through the current source when a current through the photo sensitive device 110 is so small that the bias level across the photo sensitive device 110 is above the minimum bias level. When the current source is active there will be additional shot noise from the current source and extra thermal noise from the control loop. But no additional noise will be added when the photo diode DC current is low enough to keep node N1 less than a predefined voltage (e.g. 1.2V).

When the current source 122 is active, the high pass corner frequency will not change if the error amplifier bandwidth is less than normal corner frequency. This allows the system to compensate for any amount of extra bias current without degrading the performance due to undershoot of the signals.

In an exemplary embodiment of the present invention the error amplifier 141 has a low pass behavior. When this amplifier is put into this closed loop system the closed loop system has a high pass response. The corner of the high pass closed loop response typically corresponds to the low pass bandwidth of the amplifier. If the closed loop system is designed to have the same high pass corner as the passive system, then it will not affect the system performance when the active bias is turned on or off.

In embodiments of the present invention DC current limits may be determined such that, during operation, enough bias level is obtained. Since the bias level is maintained by the control loop 140, the current limit can be set to almost any arbitrary limit. The current limit may for example range between 2mA and 5mA. The bias current that triggers a switch from the basic mode to the current cancelation mode can be adjusted by varying the threshold voltage (the predefined voltage at the node N1) and the bias resistor. The switch point current is:

$$I_{thres} = V_{thres} / R_{bias}$$

For the example values shown above the switch point current may for example be = 1.2V/ 8kΩ = 150 μA.
In a second aspect embodiments of the present invention relate to a light detection and ranging system comprising an optical detector according to embodiments of the present invention. Such a system is designed to perform a distance measurement to a target by directing an incident light beam to a target and detecting the reflected light beam. The distance to the target may be calculated based on a time of flight measurement of the incident light beam and the reflected light beam.
Lidar uses ultraviolet, visible or near-infrared light to image objects. It can target a wide range of materials. The optical detector may be adapted for recording the light amplitude (at a fixed rate) beginning from the time when the pulse is emitted and the amplitude versus time signal is used to find the reflected pulse shapes located in the scene.
LIDAR systems with a multitude of parallel channels have been proposed. Each channel comprises an optical detector in accordance with embodiments of the present invention. The signals from the photodiodes are received in an analog front end where they are converted into signals which can be processed for eventually determining the distance to the target object.
Light detection and ranging systems according to embodiments of the present invention may comprise one or more LEDs or lasers adapted to emit pulses at a certain frame rate. These may be infrared LEDs or lasers which are arranged to emit pulsed light at wavelengths above 900nm. The reflected pulses are received by the optical detector and are used to compute the distance of the optical detector from the object on which they are reflected. The light detection and ranging system may therefore comprise a processing unit. The optical detector may record the light amplitude (at a fixed rate) beginning from the time when the pulse is emitted and the amplitude versus time signal is used to find the reflected pulse shapes located in the scene. The distance may then be determined by multiplying half the round trip time with the speed of light.
In an advantageous embodiment the analog signals are oversampled to obtain a smoother trace waveform. The signals from the photodiodes may be sampled at a rate of at least 100MHz.
The reflected light amplitude reduces drastically with increasing distance. The farther an object is, the smaller the returned pulse signal becomes and there is a point at which the signal becomes completely submerged in noise. It is very important to maximize the signal to noise ratio of the system. This is possible via the accumulation process. Acquisitions are repeated multiple times (without an oversampling shift), adding the corresponding sampled values from acquisition to acquisition. This effectively creates an averaging process which reduces the random noise but keeps the real hidden pulse.
In a light detection and ranging systems according to embodiments of the present invention a pulsed laser is periodically send out and this sequence of pulses is sampled. Such system comprises a processing unit adapted for processing signals from the optical detector. Signals may be arriving frame per frame and corresponding signals may be averaged or accumulated.

In embodiments of the present invention a minimum signal to noise ratio must be obtained after accumulation. The minimum signal to noise ratio may for example be 3 dB.

In embodiments of the present invention a different resistor may be used depending on the range of the amount if incident light. Selecting a different resistor will result in a change of the corner frequency. When the corner frequency increases the undershoot after a large signal increases. A corner frequency of 200kHz may be selected as a balance such that the undershoot is limited enough and that the system performance is not affected. It is an advantage of embodiments of the present invention that not only the bias resistor can be changed to cope with a different range of incident light but that also the control circuit and the bias compensation circuit can cope with a varying background light level.

In embodiments of the present invention the resistor may be an adjustable resistor. It is thereby an advantage that different resistor values can be applied for different lighting conditions to optimize the performance under various lighting conditions.

In a third aspect embodiments of the present invention relate to a method for detecting an optical signal and converting it into an electrical signal. The method comprises receiving the optical signal with a photo sensitive device while maintaining the bias level across the photo sensitive device above a minimum bias level using a bias compensation circuit, and turning of the bias compensation circuit when a current through the photo sensitive device is so small that the bias level across the photo sensitive device is above the minimum bias level.

**Claims**

1. An optical detector (100), for converting an optical signal into an electrical signal, the optical detector (100) comprising a photo sensitive device (110) adapted for receiving the optical signal and converting it into an electrical signal, a bias compensation circuit (120) and a control circuit (140) wherein the control circuit (140) is adapted to control the bias compensation circuit to maintain a bias level across the photo sensitive device (110) above a minimum bias level, and wherein the control circuit is adapted to turn the bias compensation circuit (120) off when a current through the photo sensitive device (110) is so small that the bias level across the photo sensitive device (110) is above the minimum bias level.

2. An optical detector (100) according to claim 1, comprising a bias resistor (121)

   - wherein the bias compensation circuit (120)

comprises a variable current source (122), and wherein the photo sensitive device (110) is electrically connected in series with a parallel connection of the variable current source (122) and the bias resistor (121),
   - the optical detector (100) moreover comprises a capacitor (160) having a first and a second terminal of which the first terminal is electrically connected with a node between the bias resistor (121) and the photo sensitive device (110),
   - the control circuit (140) is adapted for controlling the current through the current source (120) such that, during operation, the bias level of the photo sensitive device (110) can be kept above the minimum bias level and such that, during operation, no current is flowing through the current source when a current through the photo sensitive device (110) is so small that the bias level across the photo sensitive device (110) is above the minimum bias level.

3. An optical detector (100) according to claim 1, wherein the control circuit (140) comprises a comparator for comparing the bias level with the minimum bias level.

4. An optical detector according to claim 1, wherein the control circuit (140) comprises a voltage measuring circuit (141) for comparing the bias level with the minimum bias level.

5. An optical detector according to claim 4 wherein the voltage measurement circuit (141) is an error amplifier (141) adapted for amplifying the difference between the bias level and the minimum bias level and for using the amplified signal for controlling the bias compensation circuit.

6. An optical detector (100) according to claim 4, wherein the voltage measurement circuit (141) is an analog-to-digital converter (141) for converting the bias level to a digital presentation and wherein the control circuit is adapted for using this digital value to control the current source (122).

7. An optical detector (100) according to claim 4, wherein the control circuit (140) comprises a voltage source (142) adapted for generating a reference voltage and wherein the control circuit is adapted for determining the minimum bias level from the reference voltage.

8. An optical detector (100) according to claim 7, wherein the voltage source (142) is adapted for adjusting the reference voltage.

9. An optical detector (100) according to claim 2 wherein the capacitor (160) and the bias resistor are selected such that a low pass filter is obtained with a corner frequency below a predefined frequency.

10. An optical detector (100) according to claim 1 wherein the bias level is an adjustable bias level.

11. An optical detector (100) according to claim 2 wherein the bias resistor (121) is an adjustable bias resistor.

12. A light detection and ranging system comprising at least one optical detector (100) according to claim 1 and a processing unit adapted for processing signals from the second terminal of the capacitor of the at least one optical detector.

13. A light detection and ranging system according to claim 12, the light detection and ranging system comprising a signal generation device adapted to emit at least one output signal and the optical detector is adapted to receive the at least one output signal.

14. A light detection and ranging system according to claim 13, wherein the signal generation device is a LED or a laser.

15. A method for detecting an optical signal and converting it into an electrical signal, the method comprising receiving the optical signal with a photo sensitive device while maintaining the bias level across the photo sensitive device above a minimum bias level using a bias compensation circuit, and turning of the bias compensation circuit when a current through the photo sensitive device is so small that the bias level across the photo sensitive device is above the minimum bias level.

3.3V

100pF

8k

## FIG. 1 (prior art)

$I_{in}$

C

$I_{out}$

R

$\dfrac{I_{out}}{I_{in}}$

log ω

## FIG. 2 (prior art)

**FIG. 3**

Europäisches
Patentamt

European
Patent Office

Office européen
des brevets

# EUROPEAN SEARCH REPORT

Application Number

EP 19 15 2525

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CN 104 359 455 B (ZHANG SHI) 7 September 2016 (2016-09-07) * paragraphs [0006] - [0021]; figures 3,4 * | 1-15 | INV. H04B10/69 |
| A | US 2009/236502 A1 (ISHII TOSHIO [JP]) 24 September 2009 (2009-09-24) * paragraphs [0040] - [0055]; figures 1,2 * | 1-15 | |
| A | US 5 254 851 A (YAMAKAWA HIDEAKI [JP] ET AL) 19 October 1993 (1993-10-19) * column 1, line 10 - column 5, line 18; figures 3,5 * | 1-15 | |

TECHNICAL FIELDS
SEARCHED      (IPC)

H04B
G01C
H01J

The present search report has been drawn up for all claims

| Place of search | Date of completion of the search | Examiner |
|---|---|---|
| Munich | 17 July 2019 | De Vries, Jane |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 3 683 983 A1**

## ANNEX TO THE EUROPEAN SEARCH REPORT
## ON EUROPEAN PATENT APPLICATION NO.

EP 19 15 2525

This annex lists the patent family members relating to the patent documents cited in the above-mentioned European search report.
The members are as contained in the European Patent Office EDP file on
The European Patent Office is in no way liable for these particulars which are merely given for the purpose of information.

17-07-2019

| Patent document cited in search report | | Publication date | Patent family member(s) | | Publication date |
|---|---|---|---|---|---|
| CN 104359455 | B | 07-09-2016 | NONE | | |
| US 2009236502 | A1 | 24-09-2009 | JP 2009260300 A | | 05-11-2009 |
| | | | US 2009236502 A1 | | 24-09-2009 |
| US 5254851 | A | 19-10-1993 | JP 3058922 B2 | | 04-07-2000 |
| | | | JP H04225630 A | | 14-08-1992 |
| | | | US 5254851 A | | 19-10-1993 |

EPO FORM P0459

For more details about this annex : see Official Journal of the European Patent Office, No. 12/82